(19) Europäisches Patentamt
European Patent Office
Office européen des brevets

(11) Veröffentlichungsnummer: **0 603 661 A1**

(12) **EUROPÄISCHE PATENTANMELDUNG**

(21) Anmeldenummer: 93119848.5

(51) Int. Cl.5: **H03D 3/00**

(22) Anmeldetag: **09.12.93**

(30) Priorität: **24.12.92 DE 4244144**

(43) Veröffentlichungstag der Anmeldung:
**29.06.94 Patentblatt 94/26**

(84) Benannte Vertragsstaaten:
**AT CH ES GB IT LI**

(71) Anmelder: **ANT Nachrichtentechnik GmbH**
**Gerberstrasse 33**
**D-71522 Backnang(DE)**

(72) Erfinder: **Göckler, Heinz, Dr.-Ing.**
**Elbinger Strasse 52**
**D-71522 Backnang(DE)**

(54) **Verfahren zur Demodulation von frequenzmodulierten Signalen.**

(57) Verfahren zur Demodulation von frequenzmodulierten Signalen wobei mittels Tiefpaßfilter gefiltert wird und wobei anschließend mittels komplexer Multiplikation (Verzögerungsdemodulation) das gewünschte Phaseninkrement und damit das übertragene Signal gewonnen wird, dadurch gekennzeichnet, daß das abgetastete Empfangssignal einer Filterung mit einem Bandfilter unterzogen wird und daß dieses Filter komplexwertige Koeffizienten aufweist.

Verfahren sehr aufwandsgünstig, Einsatz insbesondere bei der Demodulation von UKW-FM-Signalen.

FIG.2b

EP 0 603 661 A1

Die Erfindung betrifft ein Verfahren zur Demodulation von frequenzmodulierten Signalen gemäß Oberbegriff des Anspruches 1. Solche digitale Verfahren zur Demodulation von kontinuierlich modulierten FM-Signalen, also nicht FSK, welche zum eigentlichen Demodulationsprozeß komplexwertige Signale benötigen und verarbeiten, sind bekannt, beispielsweise durch den Aufsatz "Equalization Problems in a digital FM Receiver" von Kammeyer in Signal Processing 9 (1985) Seiten 263-276, wobei es sich um einen sogenannten Verzögerungsdemodulator handelt.

Aus der Dissertation "Die Demodulation frequenzumgetasteter Signale mit Bandbreiten in der Größenordnung der Mittenfrequenz" von Ruopp, Universität Stuttgart 1975 ist die Blockstruktur eines mit Differentiation arbeitenden Demodulationsverfahren bekannt geworden.

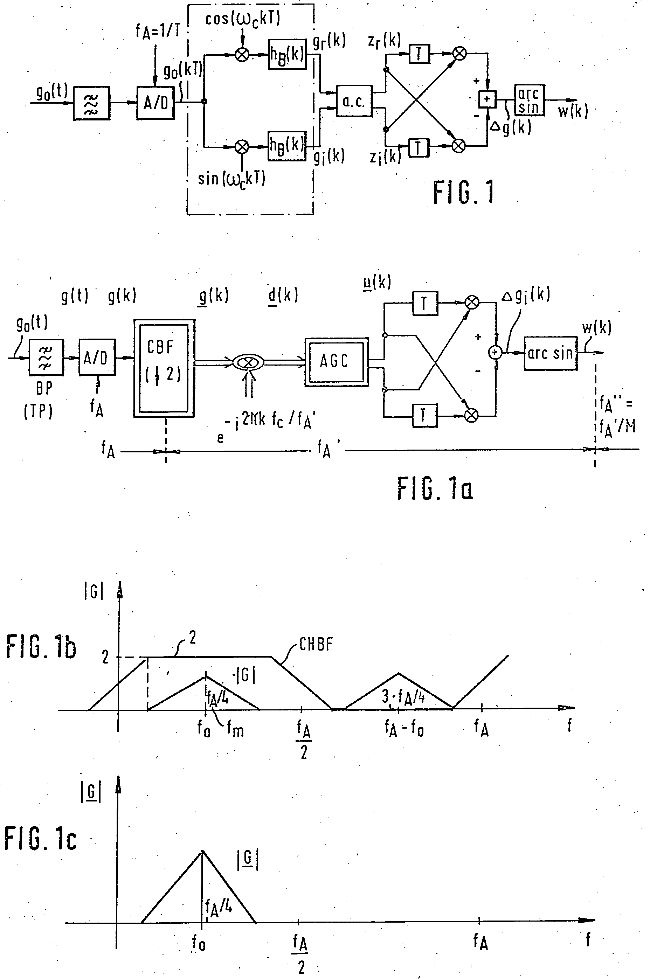

Bei all diesen Verfahren ist es erforderlich, aus dem urprünglich reellwertigen FM-Eingangssignal $g_o(t)$ ein komplexwertiges Signal abzuleiten in Form einer Normal- und einer Quadraturkomponente (Real- und Imaginärteil). Diese Komponenten werden erzeugt, indem das abgetastete Eingangssignal mit zwei zueinander orthogonalen Trägersignalen multipliziert wird (Mischer) und anschließend mittels zweier nachgeschalteter identischer Tiefpässe zur Unterdrückung unerwünschter Mischprodukte gefiltert werden. Die dazu notwendige Schaltungsanordnung ist in Figur 1 strichliert umrandet.

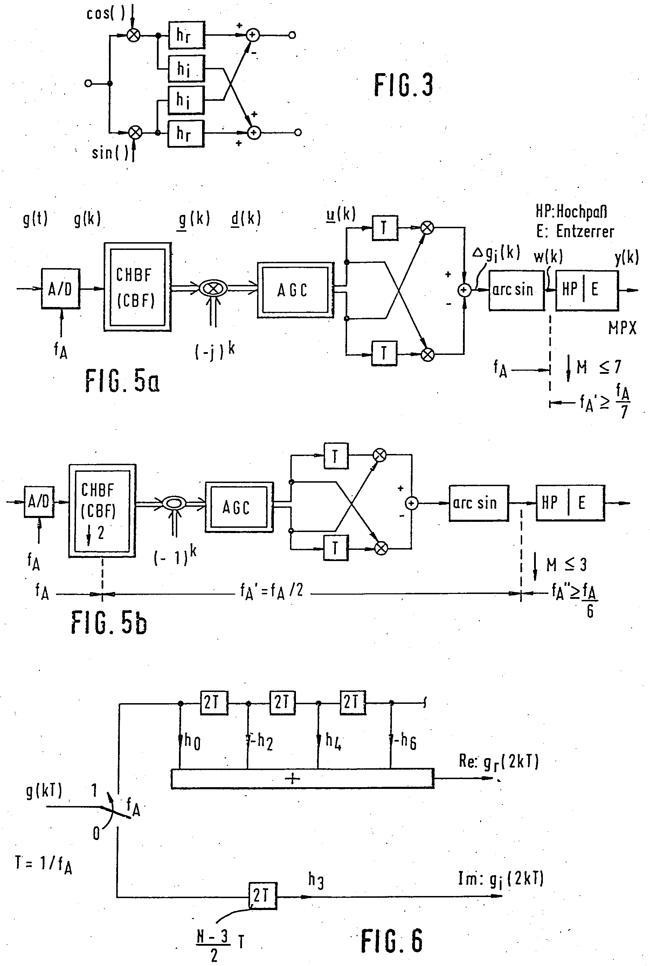

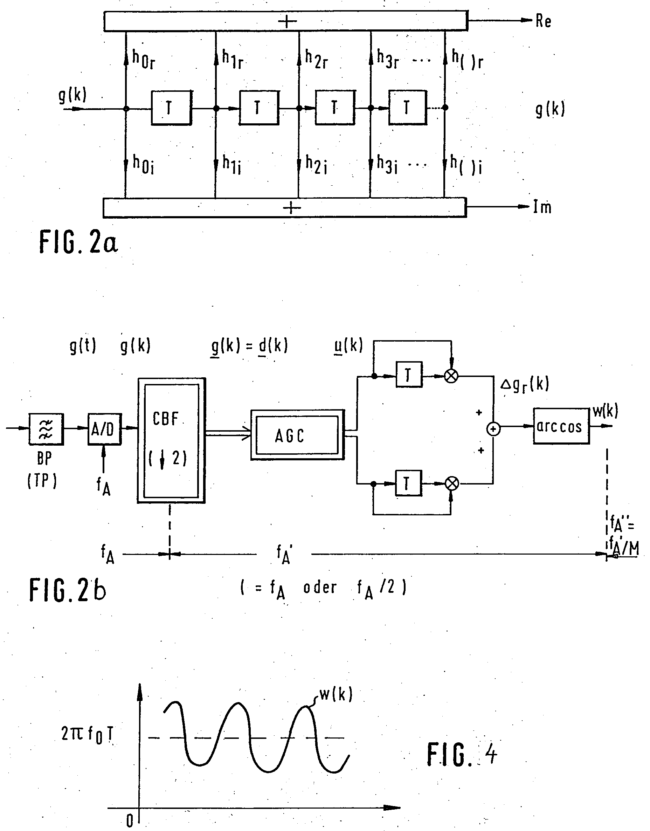

Wenn die Filterkombination $h_B$ zusätzlich die Aufgabe übernehmen soll, den bezüglich der Mittenfreguenz unsymmetrischen Frequenzgang des analogen Vorfilters zu entzerren, dann enthält der gestrichelte Block der Figur 1 vier Teilfilter, wie in Figur 3 gezeigt wird.

Der vorliegenden Erfindung lag die Aufgabe zugrunde, ein Verfahren der eingangs genannten Art anzugeben, welches in der Lage ist, Demodulationssignale gleicher oder sogar höherer Qualität zu erzeugen unter Verminderung des Aufwandes.

Diese Aufgabe wurde gelöst mit den Mitteln des Anspruches 1. Vorteilhafte Ausgestaltungen ergeben sich durch die Unteransprüche.

Das erfindungsgemäße Demodulationsverfahren erfordert wesentlich weniger Schaltungsaufwand und liefert qualitativ mindestens gleichwertige Demodulationsprodukte. Das Verfahren ist auch dann anwendbar, wenn beliebige Frequenzverschiebung gewünscht wird.

Es folgt nun die Beschreibung anhand der Figuren.

Die Figur 1 zeigt das grundlegende Blockdiagramm für einen digitalen FM-Demodulator nach Kammeyer.

Die Figur 3 zeigt die Anordnung aus vier Teilfiltern, wenn die Filterkombination $h_B$ in dem strichlierten Block der Figur 1 zusätzlich die Aufgabe der Entzerrung übernimmt.

Die Figuren 1a, 5a, 5b und 2b schließlich zeigen Anordnungen, die nach dem erfindungsgemäßen Verfahren arbeiten. In Figur 2a und 6 sind Strukturen für ein Prototypfilter zur Erzeugung eines komplexwertigen Ausgangssignals aus einem reellwertigen Eingangssignal dargestellt.

Im Blockschaltbild gemäß Figur 1 werden die einzelnen Verarbeitungsschritte des eingangsseitigen Empfangssignals gezeigt:

Das durch den Zwischenfrequenzmischer in eine Zwischenfrequenzlage heruntergemischte Empfangssignal $g_0(t)$ wird über ein analoges Vorfilter auf einen Analog/Digitalumsetzer geleitet, abgetastet und anschließend mittels zweier orthogonalen Trägersignale in ein komplexwertiges Signal gewandelt, welches über die Tiefpaßfilterfunktion $h_B$ in beiden Zweigen von störenden Mischprodukten befreit wird. Daran anschließend erfolgt eine Amplitudensteuerung, womit Amplitudenschwankungen ausgeglichen werden, welche dadurch entstehen, daß das von Hause aus unbegrenzte Spektrum eines FM-Signals in technischen Systemen mit eingeschränkten Kanalbandbreiten notwendigerweise bandbegrenzt werden muß. Nach der Amplitudensteuerung folgt der eigentliche Demodulator, hier ein Verzögerungsdemodulator welcher mittels einer komplexen Multiplikation der folgenden Form

$$g(k) = Im \{\underline{g}(k) \cdot \underline{g}*(k-1)\} = sin [w(k)]$$

$$= sin [\varphi(k) - \varphi(k-1)]$$

das gewünschte Phaseninkrement erzeugt, woraus dann mittels einer anschließenden Arcussinuskonversion das demodulierte Signal (k) gewonnen wird: (k) = $\omega_o T[1 + \alpha \cdot w(k)]$. ($\underline{g}*$ ist der konjugiert komplexe Wert zu $\underline{g}$; komplexwertige Größen sind durch Unterstreichungen gekennzeichnet).

In Figur 3 sind die vier Teilfilter zweimal $h_r$ und zweimal $h_i$ erkennbar, welche außer der Filterung $h_B$ nach Figur 1 auch noch die Aufgabe der Entzerrung übernehmen, die aufgrund möglicher Verzerrungen des analogen Vorfilters notwendig sein kann. Am meisten störend wirken sich hier Unsymmetrien des Analogfilters bezüglich der Trägerfrequenz des FM-Signals aus.

Die Figur 1b und 1c zeigen den Frequenzgang eines für die Bandfilterung eingesetzten komplexen Halbbandfilters CHBF zur Umwandlung des reellwertigen Signals g(k) in das zugehörige komplexwertige Signal $\underline{g}$(k), wobei das Halbbandfilter keine Entzerrungsfunktion wahrnimmt. Im folgenden sind die Mittenfrequenzen definiert

$f_m$ : des komplexen Filters CBF
(bei CHBF $f_m$ = $f_A$/4)

$f_O$ : des FM-Spektrums

$f_c$ : Trägerfrequenz des Mischers
($f_c$ = $f_o$ oder $f_c$ / $f_o$)

Die Filtermittenfrequenz $f_m$ von CHBF ist gleich einem Viertel der Abtastfrequenz, und der Übergangsbereich des Halbbandfilters liegt symmetrisch zur halben Abtastfrequenz. Im übrigen gilt für dieses komplexe Halbbandfilter, daß der absolute Rippel $\delta p$ = $\delta s$ ist, d.h. die Abweichung von eins im Durchlaßbereich ist identisch gleich der Abweichung von 0 im Sperrbereich. In Figur 1b ist zusätzlich das Spektrum |G| eines reellen mit der Abtastfrequenz $f_A$ abgetasteten Empfangssignals eingezeichnet, dessen Spektrum folglich symmetrisch zur halben Abtastfrequenz ($f_A$/2) ist und das sich aufgrund der Abtastung

periodisch wiederholt. Wie in Fig. 1b dargestellt, muß die Bandmittenfrequenz $f_o$ des Spektrums |G| nicht mit der Filtermittenfrequenz $f_m$ übereinstimmen. In Figur 1c ist das Spektrum |G| des komplexen Signals $\underline{g}$(k) gezeichnet, welches bei der Bandmittenfrequenz $f_o$ zentriert liegt; es ist erkennbar, wie sämtliche zu $f_A$/2 spiegelbildlichen Spektralanteile unterdrückt werden.

Die Figur 1a zeigt ein allgemeines Blockschaltbild für die erfindungsgemäße Lösung beispielsweise mit einem Arcus-Sinus-Verzögerungsdemodulator. Das Eingangssignal $g_0$(t) weist ein unendliches Spektrum auf, sodaß bei jeder Wahl der Abtastfrequenz das Abtasttheorem verletzt wird und eine nichtlineare Verzerrung erzeugt wird. Die Abtastrate ist so festzulegen, daß mindestens im Bereich der Carson-Bandbreite B = 300 kHz keine merkliche Überfaltung geschieht. Mittels eines analogen Band- oder Tiefpasses wird das Eingangssignal gefiltert, bevor es dann im Analog-Digital-Umsetzer A/D abgetastet und digitalisiert wird. Die Ausgangsgröße g(k) wird erfindungsgemäß einen komplexen Bandfilter CBF (Filter mit komplexwertigen Koeffizienten) zugeführt, welches wahlweise mit unverminderter oder verminderter Abtastrate (zur Reduktion dr Abtastrate) arbeiten kann und das komplexe Signal $\underline{g}$(k) erzeugt, welches mit Hilfe einer komplexen Trägermultiplikation mit

$e^{-j2\pi \, kf_c/f_A'}$ frequenzverschoben wird. Anschließend kann eine Amplitudenregelung AGC erfolgen, welche aus dem ungeregelten Signal $\underline{d}$(k) das geregelte (betragskonstante) komplexe Signal $\underline{u}$(k) erzeugt. Dieses Signal wird nunmehr einem Verzögerungsdemodulator zugeführt, welcher mittels komplexer Multiplikation das Signal

$$g_i(k) = \sin \{\triangle\omega T + \triangle\Omega \int_{(k-1)T}^{kT} v(\tau)\, d\tau\}$$
$$\approx \sin \{\triangle\omega T + \triangle\Omega \, T \cdot v(k)\} ; \quad (T = 1/f_A') \qquad (15a)$$

erzeugt, welches anschließend einer Arcus-Sinus-Konversion zur Erzeugung des gewünschten Phaseninkrementes w(k) unterzogen wird.

Das Signal w(k) enthält dann einen Gleichanteil, wenn in Gl. (15a)$\triangle\omega$ = $2\pi$ ($f_o$ - $f_c$) ≠ 0 ist.

Dieser u.U. störende Gleichanteil läßt sich dadurch eliminieren, daß er z.B. durch Mittelung des Signals gemessen wird und dieser Mittelwert zur Regelung der Trägerfrequenz $f_c$ in Fig. 1a herangezogen/verwendet wird, derart daß $f_c$ -> $f_o$ geht ($f_c$ ≈ $f_o$).

Die Figuren 5a und 5b zeigen zwei Sonderfälle der Figur 1a, wobei im Fall der Figur 5a die Trägerfrequenz $f_c$ gleich dem Viertel der Ausgangsabtastfrequenz des CBF ist, sodaß der komplexe Träger die einfache Form $(_{-j})^k$ annimmt, da $f_o$ ≈ $f_A$/4. Nach der Arcus-Sinus-Konversion kann in vorteilhafter Weise noch eine Hochpaßfilterung zur Elimination eines restlichen Gleichanteils und gegebenenfalls eine anschließende Entzerrung E erfolgen.

Die eingangsseitige direkt nach der Analog-Digital-Umsetzung erfolgende Filterung ist mit einem komplexen Halbbandfilter CHBF oder einem komplexen Bandfilter CBF beispielsweise gemäß der Struktur nach Figur 2a durchzuführen; diese Struktur zeigt die allgemeinste Form ohne Verminderung der Abtastfrequenz.

Bei der Struktur gemäß Figur 5b ist ein komplexes Halbbandfilter CHBF oder ein komplexes Bandfilter CBF mit Abtastratenhalbierung eingesetzt; in diesem Fall erfolgt eine komplexe Trägerung mit den einfachen Werten $(_{-1})^k$, da $f_o$ ≈ $f_A'$/2 ist ($f_A'$ : Ausgangsabtastfrequenz).

Das Blockschaltbild Figur 2b zeigt eine Variation eines FM-Demodulators mittels eines Arcus-Cosinus-Verzögerungsdemodulators und einer anschließenden Arcus-Cosinus-Konversion. Bei diesem Verzögerungsdemodulator wird nach folgender Gleichung

$$\triangle g_r(k) \;=\; \cos\, \{ \triangle\omega T + \angle\Omega \int_{(k-1)\tau}^{kT} v\,(\tau)\; d\,\tau \}$$

$$\approx\; \cos\, \{ \triangle\omega T + \triangle\Omega\; T\cdot v\,(k)\, \} \tag{15b}$$

vorgegangen, wobei der Realteil der komplexen Größe $\underline{g}(k)$ weiterverarbeitet wird. Bei dieser Lösung ist zur Filterung nach dem Analog-Digital-Umsetzer ein komplexes Bandfilter CBF oder CHBF mit oder ohne Abtastratenhalbierung einzusetzen, wobei eine komplexe Trägerung entfällt, wenn die Bandmittenfrequenz $f_o$ ungefähr gleich dem Viertel der Eingangsabtastrate $f_A$ ist.

Der Eindeutigkeitsbereich für die benötigte Arcus-Cosinus-Konversionsfunktion ist gegeben durch die Gleichung

$$0 \prec 2\pi f_o \cdot T + \Delta\omega T\, v(k) < \pi \tag{16b}$$

wenn Arcus-Cosinus unmittelbar in seinem Hauptwertebereich realisiert wird, so resultiert ein Ausgangssignal $W(k) = 2\Pi f_o \cdot T + \Delta\omega \cdot T \cdot v(k)$, wobei $f_o$ ungefähr dem Viertel der Abtastrate ist und die nichtveränderte Mittenfrequenz des Spektrums des Signals darstellt (Fig. 4). Die Funktion W(k) weist damit einen hohen Gleichanteil auf, der mittels Hochpaßfilterung eliminiert werden kann oder durch einen festen Offset von $\pi/2$ von vorneherein in die Arccos-Berechnung einzurechnen ist.

## Patentansprüche

1. Verfahren zur Demodulation von frequenzmodulierten Signalen der Form $g(t) = a(t) \cdot \text{Cosinus}\,[\phi(t)]$ mit der Augenblicksfrequenz $\omega(t) = d\phi(t)/dt = \omega_o[1 + \alpha \cdot v(t)]$, wobei das Empfangssignal $g_0(t)$ mit der Abtastfrequenz $f_A = 1/T$ abgetastet wird zu

$$g_0(k) \;=\; a(k)\; \cdot\; \cos\, [\, \Psi\,(kT)\,]$$
$$=\; a(k)\; \cdot\; \cos\, [\, \omega_o\; kT + \Psi\,(kT)\,]\,,$$

$$\text{mit}\; \Psi(k) \approx \Delta\Omega\cdot\, T \sum_{-\infty}^{k}\, (k)\,,$$

mit dem übertragenen Signal (k), der Schrittzahl k, der Schritt-Taktlänge T, dem Frequenzhub $\Delta\Omega = \alpha \cdot \omega_0$, der Bezugsfrequenz $\omega_0 = 2\pi f_o$ und mit der durch Bandbegrenzung auf der Übertragungsstrecke bedingten in zeitlicher Abhängigkeit t schwankenden Amplitude a(t) bzw. a(k), wobei mittels Tiefpaßfilter (zur Unterdrückung unerwünschter Spektralanteile) gefiltert ($h_B$) wird zu $\underline{g}$ - (kT) und wobei anschließend mittels komplexer Multiplikation

$$\Delta\,\underline{g}(k) = g(k) \cdot g^*(k\text{-}1) = e^{j}\,[\Delta\omega\cdot\, T + \Delta\Omega\cdot T\cdot v(k)]$$
(Verzögerungsdemodulation)

das gewünschte Phaseninkrement $W(k) = \omega_0 \cdot T[1 + \alpha \cdot V(k)]$ und damit das (zu) übertragen(d)e Signal v(k) aus dem Real- oder Imaginärteil von $\Delta\,\underline{g}(k)$ gewonnen wird, dadurch gekennzeichnet, daß das abgetastete Empfangssignal $g_0(kT)$ einer Filterung mit einem Bandfilter unterzogen wird und daß dieses Filter komplexwertige Koeffizienten $\underline{h}(k)$ aufweist.

2. Verfahren nach Anspruch 1, dadurch gekennzeichnet, daß die komplexwertigen Koeffizienten $\underline{h}(k)$ aus einem Filter mit reellen Koeffizienten h(k) abgeleitet sind.

3. Verfahren nach Anspruch 1 oder 2, dadurch gekennzeichnet, daß vor der komplexen Multiplikation eine automatische Amplitudenregelung (AGC) erfolgt.

4. Verfahren nach Anspruch 1, 2 oder 3, dadurch gekennzeichnet, daß bei der komplexen Multiplikation der Imaginärteil $\Delta gi(k)$ gebildet und anschließend einer Arcus-Sinus-Konversion zu W(k) unterzogen wird (Fig. 1a).

5. Verfahren nach Anspruch 4, dadurch gekennzeichnet, daß nach der Bandfilterung mittels einer komplexen Trägermultiplikation der Form $g(k) \cdot e^{j\omega_c kT}$ frequenzverschoben wird.

6. Verfahren nach Anspruch 1, 2 oder 3, dadurch gekennzeichnet, daß bei der komplexen Multiplikation der Realteil $\Delta gr(k)$ gebildet und anschließend einer Arcus-Cosinus-Konversion zu (k) unterzogen wird (Fig. 2b).

7. Verfahren nach Anspruch 5, dadurch gekennzeichnet, daß die Trägerfrequenz $f_c$ gleich dem Viertel der Abtastfrequenz $f_A$ ist ($f_c = f_A/4$), so daß die Träger-Multiplikation mit $(-j)^k$ erfolgt (Fig. 5a).

8. Verfahren nach Anspruch 5, dadurch gekennzeichnet, daß die Abtastfrequenz $f_A$ im komplexen Bandfilter halbiert wird und daß die Trägerfrequenz $f_c$ gleich der halbierten Ausgangsabtastfrequenz $f_A'$ ist ($f_c = f_{,A}/2 = f_A/4$), so daß die Träger-Multiplikation mit $(-1)^k$ erfolgt (Fig. 5b).

9. Verfahren nach Anspruch 7 oder 8, dadurch gekennzeichnet, daß die Trägerfrequenz $f_c$ gleich der Signalmittenfrequenz $f_0$ ist

($f_c = f_0$).

10. Verfahren nach Anspruch 7 oder 8, dadurch gekennzeichnet, daß die Trägerfrequenz $f_c$ ungleich der Signalmittenfrequenz $f_0$ ist und daß der Arcus-Sinus- bzw. Arcus-Cosinus-Konversion ein Hochpass nachgeschaltet ist.

11. Verfahren nach Anspruch 5, 7 oder 8, dadurch gekennzeichnet, daß die Trägerfrequenz $f_c$ ungleich der Signalmittenfrequenz $f_0$ ist und daß die Trägerfrequenz mittels des vorhandenen oder eines zusätzlichen Mischers auf die Signalmittenfrequenz $f_0$ (nach) geregelt wird.

12. Verfahren nach einem der vorhergehenden Ansprüche, dadurch gekennzeichnet, daß vor der Analog-Digital-Umsetzung eine Band- oder Tiefpaßfilterung erfolgt.

13. Verfahren nach Anspruch 12, dadurch gekennzeichnet, daß das komplexe Bandfilter (CBF) eine FIR-Struktur (mit endlicher Impulsantwort) aufweist (Fig. 2a).

14. Verfahren nach Anspruch 12, dadurch gekennzeichnet, daß das komplexe Bandfilter ein Halbbandfilter CHBF ist, wobei seine Filtermittenfrequenz $f_m$ identisch dem Viertel der Abtastfrequenz $f_A$ ist.

FIG.1

FIG.1a

FIG.1b

FIG.1c

FIG.3

HP: Hochpaß
E: Entzerrer

FIG. 5a

FIG. 5b

FIG. 6

7

FIG. 2a

FIG. 2b

( = $f_A$ oder $f_A/2$ )

FIG. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| Y | EP-A-0 458 452 (TECHNOPHONE LIMITED) * Seite 2, Zeile 32 - Seite 5, Zeile 53; Abbildungen 2,3B-4B * --- | 1-14 | H03D3/00 |
| D,Y | SIGNAL PROCESSING Bd. 9, Nr. 4 , Dezember 1985 , NORTH-HOLLAND NL Seiten 263 - 276 K.D. KAMMEYER 'EQUALIZATION PROBLEMS IN A DIGITAL FM RECEIVER' * Seite 264, Zeile 8 - Seite 264, Zeile 20; Abbildung 1 * --- | 1-14 | |
| Y | EP-A-0 184 018 (BLAUPUNKT-WERKE GMBH) * Seite 6, Zeile 21 - Seite 10, Zeile 18; Abbildungen 1,5,6 * --- | 1-14 | |
| A | US-A-5 057 786 (SYUUICHI YOSHIKAWA) * Spalte 2, Zeile 15 - Spalte 2, Zeile 48; Abbildungen 1,4 * --- | 1 | |
| A | US-A-4 947 408 (R. SADR) * Spalte 2, Zeile 54 - Spalte 3, Zeile 40; Abbildungen 1,3 * ----- | 1,8,14 | RECHERCHIERTE SACHGEBIETE (Int.Cl.5) H03C H03D |

Der vorliegende Recherchenbericht wurde für alle Patentansprüche erstellt

| Recherchenort | Abschlußdatum der Recherche | Prüfer |
|---|---|---|
| DEN HAAG | 4. März 1994 | Dhondt, I |